# EUROPEAN PATENT APPLICATION

(11) **EP 3 660 068 A1**
(43) Date of publication of application: **03.06.2020**
(21) Application number: 18837842.6
(22) Date of filing: 29.06.2018
(51) Int. Cl.: C08G 59/02, C08K 5/3445, C08K 5/3492, C08G 59/62, C08K 5/5415, C08K 5/14, C08K 5/5313, C08K 3/017, H01L 23/29

(54) **EPOXY RESIN COMPOSITION AND SEMICONDUCTOR DEVICE COMPRISING SAME**

(30) Priority: 27.07.2017 KR 20170095287
(71) Applicant: KCC Corporation, Seoul 06608 (KR)
(72) Inventor: PARK, Ji Seung, Wanju-gun Jeollabuk-do 55317 (KR); PARK, Chan Young, Wanju-gun Jeollabuk-do 55317 (KR); SHIM, Myoung Taek, Gwangju 62246 (KR); JEON, Ki Young, Dongducheon-si Gyeonggi-do 11325 (KR); LEE, Sang Sun, Seongnam-si Gyeonggi-do 13625 (KR)
(74) Representative: Patentwerk B.V.
(86) International application number: PCT/KR2018/007381
(87) International publication number: WO 2019/022390

(57) **Abstract**

The present invention provides an epoxy resin composition comprising an epoxy resin, a curing agent, a coupling agent, a curing accelerator, and an adhesion promotor, the adhesion promotor comprising an imidazole-based compound having an average particle size of 0.1-5 µm, and a semiconductor device comprising the same. The epoxy resin composition of the present invention has high adhesion to a different kind of material, such as copper, nickel, or silver, and thus, may satisfy a high level of reliability required for a semiconductor for a car, such as MSL or TCT.

## Description

### TECHNICAL FIELD

The present invention relates to an epoxy resin composition and a semiconductor device including the same.

### BACKGROUND ART

About 200 semiconductors such as a memory/non-memory, a power semiconductor, a micro control unit (MCU), and the like are used as semiconductors for a car. A general car has 40 semiconductors on average, and a high-end car has 100 or more semiconductors built thereinto. A semiconductor for a car must satisfy stricter quality standards (AEC-Q101) required for automotive applications such as temperature, humidity, defect rate, warranty life, and the like, than a household semiconductor or an industrial semiconductor. Accordingly, the level of properties required for an epoxy resin composition which is a sealing material of a semiconductor is also getting higher.

Recently, the application fields of a semiconductor for a car have been rapidly expanded, and the market size of the semiconductor for a car has been sharply increased. Particularly, the demand for a discrete power semiconductor is continuously increasing. With the rapid growth of the market for the discrete power semiconductor for a car, there is a growing demand for a change in the package of a lead from a board insertion-mount manner to a surface mount manner. As a result, more semiconductor assembly companies have entered the market for a discrete semiconductor for a car, so that competition continues to intensify.

Therefore, in order to secure price competitiveness (for example, process shortening), semiconductor assembly companies use a lead frame made of a variety of materials, the lead frame being mainly plated with copper, nickel, silver, or the like. However, due to the deterioration in adhesion with an encapsulation material, copper, nickel, and silver materials have a problem in that peeling occurs in the moisture sensitivity level (MSL) and a thermal cycle test (TCT), which are important reliability items required for a semiconductor for a car, so that the reliability of the semiconductor is not satisfied.

### DISCLOSURE OF THE INVENTION

### TECHNICAL PROBLEM

The present invention provides an epoxy resin composition and a semiconductor device including the same, the composition having excellent adhesion to copper, nickel, and silver materials, and satisfying the reliability specification of a surface mount-type semiconductor for a car.

### TECHNICAL SOLUTION

An aspect of the present invention provides an epoxy resin composition comprising an epoxy resin, a curing agent, a coupling agent, a curing accelerator, and an adhesion promotor, the adhesion promotor comprising an imidazole-based compound having an average particle size of 0.1-5 µm.

Another aspect of the present invention provides a semiconductor device including the epoxy resin composition.

### ADVANTAGEOUS EFFECTS

An epoxy resin composition of the present invention has high adhesion to a different kind of material, such as copper, nickel, or silver, and thus, may satisfy a high level of reliability required for a semiconductor for a car, such as MSL or TCT.

### BEST MODE

Hereinafter, the present invention will be described in detail.

### 1. Epoxy resin composition

An aspect of the present invention provides an epoxy resin composition.

The epoxy resin composition comprises an epoxy resin, a curing agent, a coupling agent, a curing accelerator, and an adhesion promotor.

The epoxy resin is not particularly limited as long as it is an epoxy resin commonly used for semiconductor sealing, and is preferably an epoxy compound containing two or more epoxy groups in one molecule. For example, at least one or a mixture of two or more selected from the group consisting of a bisphenol A-type epoxy resin, an alicyclic-type epoxy resin, a cresol novolac-type epoxy resin, a dicyclopentadiene-type epoxy, and a biphenyl epoxy resin may be used as the epoxy resin.

The content of the epoxy resin may be 2-20 parts by weight, for example, 6-10 parts by weight, based on 100 parts by weight of the epoxy resin composition. When the content of the epoxy resin is less than 2 parts by weight, adhesion, flowability, and moldability may be deteriorated. When the content thereof is greater than 20 parts by weight, the reliability of a semiconductor is deteriorated due to the increase of moisture absorption, and strength may be deteriorated due to the decrease in the relative content of a filler to be described later.

The curing agent is a component for proceeding the curing of the composition by reacting with the epoxy resin, and is preferably a curing agent containing two or more phenolic hydroxyl groups in one molecule. For example, at least one or a mixture of two or more selected from the group consisting of a phenol novolac resin, a cresol novolac resin, a phenol aralkyl resin, and a polyfunctional phenol compound may be used as the curing agent.

The content of the curing agent may be 1-20 parts by weight, for example, 3-7 parts by weight, based on 100 parts by weight of the epoxy resin composition. When the content of the curing agent is less than 1 part by weight, curability and moldability may be problematic. When greater than 20 parts by weight, reliability may be deteriorated due to the increase of moisture absorption, and strength may become relatively low.

The epoxy resin and the curing agent may be preferably mixed in an equivalent ratio of 1:0.6 to 1:1.3 depending on the requirements of mechanical properties and moisture resistance reliability in a semiconductor for a car. There is a trend in which when an active group of the curing agent is less than 0.6 equivalents with respect to 1 equivalent of the epoxy group, the curing rate of the entire resin composition is delayed, and when greater than 1.3 equivalents, the strength of a cured product after the final curing is reduced. Also, when the range of an active group of the curing agent is outside the range of 0.6-1.3 equivalents with respect to 1 equivalent of the epoxy group, high-temperature thermal decomposition may occur due to an unreacted epoxy group or an unreacted curing agent.

The coupling agent is not particularly limited as long as it is commonly used for semiconductor sealing. For example, at least one or a mixture of two or more selected from the group consisting of epoxy silane, mercapto silane, and amino silane may be used as the coupling agent.

The content of the coupling agent may be 0.01-2.0 parts by weight, for example, 0.05-1.0 parts by weight, based on 100 parts by weight of the epoxy resin composition. When the content of the coupling agent is less than 0.01 parts by weight, the strength may be deteriorated due to the reduction in the coupling effect between an organic material and an inorganic material. When greater than 2.0 parts by weight, gel formation may be problematic.

The curing accelerator is a component for accelerating the curing reaction between the epoxy resin and the curing agent. At least one or a mixture of two or more selected from the group consisting of an amine-based compound and an organic phosphine compound may be used as the curing accelerator.

For example, as the amine-based compound, at least any one selected from the group consisting of benzyldimethylamine, triethanolamine, triethylenediamine, diethylaminoethanol, tri(dimethylaminomethyl)phenol, 2,4,6-tris(diaminomethyl)phenol, and tri-2-ethylhexyl acid may be used.

For example, as the phosphine compound, at least any one selected from the group consisting of tris-4-methoxyphenylphosphine, tetrabutylphosphonium bromide, butyltriphenylphosphonium bromide, phenylphosphine, diphenylphosphine, triphenylphosphine, triphenylphosphine triphenylborane, triphenylphosphine-1, 4-benzoquinone may be used.

The content of the curing accelerator may be 0.05-5 parts by weight, for example, 0.1-3 parts by weight, based on 100 parts by weight of the epoxy resin composition. When the content of the curing accelerator is less than 0.05 parts by weight, gelation time is increased so that optimal workability may not be secured. When greater than 5 parts by weight, gelation time is excessively shortened so that moldability may be deteriorated.

The adhesion promotor is a component for improving adhesion to a lead frame plated with a material such as copper, nickel, or silver. An imidazole-based compound having an average particle size of 0.1-5 µm, for example, an imidazole-based compound having an average particle size of 0.5-2.5 µm may be used as the adhesion promotor. When the average particle size of the imidazole-based compound is less than 0.1 µm, dispersion is reduced since agglomeration is facilitated by mutual attractive force during mixing, and thus, adhesion may be deteriorated. When the average particle size is greater than 5 µm, the contact area with an adherend of copper, nickel and silver materials is reduced due to the reduction in specific surface area, and thus, adhesion may be deteriorated.

As the imidazole-based compound, a compound having a chemical structure represented by Formula 1 below may be used.

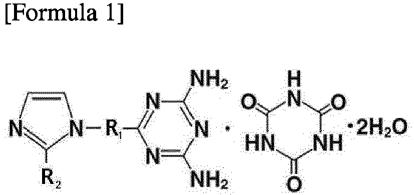

In Formula 1 above, R₁ is an alkylene group having 1 to 6 carbon atoms, and R₂ is an alkyl group having 1 to 6 carbon atoms. For example, R₁ may be an alkylene group having 1 to 4 carbon atoms, and R₂ may be an alkyl group having 1 to 4 carbon atoms. In another example, R₁ may be an alkylene group having 1 to 2 carbon atoms, and R₂ may be an alkyl group having 1 to 2 carbon atoms. For example, R₁ may be any one of a methylene group and an ethylene group, and R₂ may be any one of a methyl group and an ethyl group.

The adhesion promotor may be used in an amount of 0.01-0.5 parts by weight based on 100 parts by weight of the epoxy resin composition. When the content of the adhesion promotor is less than 0.01 parts by weight, sufficient adhesion may not be secured. When greater than 0.5 parts by weight, H₂O molecules are increased in the structure so that adhesion may be deteriorated due to a vaporization at the bonding interface during molding.

The epoxy resin composition may further include a filler in order to improve the mechanical properties (for example, strength) of the epoxy resin composition and lower the amount of moisture absorption. For example, as the filler, at least one selected from the group consisting of silica, silica nitride, alumina, aluminum nitride and boron nitride may be used. The shape of the filler is not particularly limited. A filler in prismatic and spherical forms may be used. For example, natural silica, synthetic silica, fused silica, and the like may be used. As an example, a spherical silica particle may be used. The particle diameter of the filler is preferably 150 µm or less in consideration of the fillability in a mold.

The content of the filler may be 70-91 parts by weight, for example, 75-89 parts by weight, based on 100 parts by weight of the epoxy resin composition. When the content of the filler is less than 70 parts by weight, the amount of moisture absorption in a cured product of the epoxy resin composition is increased and the increase of moisture absorption may cause the deterioration in reliability of a semiconductor device. When greater than 91 parts by weight, fluidity loss is caused so that moldability defects may occur.

In addition, the epoxy resin composition of the present invention may further include an additive commonly used in an epoxy resin composition for semiconductor sealing. The additive may be various components commonly used in the art, including a flame retardant, a coloring agent, a release agent, or a low-stress agent.

The epoxy resin composition itself may exhibit excellent flame retardancy. However, in order to further improve the flame retardancy, the epoxy resin composition may further include a flame retardant. As the flame retardant, a metal hydroxide, a phosphorus and nitrogen-containing organic compound (for example, resorcinol diphosphate, phosphate, phenoxyphosphazene, melamine cyanurate, and phenolic melamine resin), and the like may be used alone or in a mixture of two or more thereof. However, the embodiment of the present invention is not limited thereto. As the metal hydroxide, a hydroxide of a metal selected from magnesium, calcium, strontium, barium, boron, aluminum, and gallium may be used.

As the coloring agent, a typical coloring agent such as carbon black, an organic dye, and an inorganic dye may be used alone or in a mixture of two or more thereof.

As the release agent, a typical release agent such as a long-chain fatty acid, a metal salt of a long-chain fatty acid, paraffin wax, and carnauba wax may be used alone or in a mixture of two or more thereof.

As the low-stress agent, a typical low-stress agent such a modified silicone resin and modified polybutadiene may be used alone or in a mixture of two or more thereof.

Each additive may be included in an amount of 0.1-5 parts by weight based on 100 parts by weight of the epoxy resin composition, but the embodiment of the present invention is not limited thereto.

The method for producing the epoxy resin composition is not particularly limited, and the epoxy resin composition may be produced using a method known in the art. For example, a melt kneading method known in the art, the method using a banbury mixer, a kneader, a roll, a uniaxial or biaxial extruder, a co-kneader, or the like may be used. As an example, the epoxy resin composition of the present invention may be obtained through a general process in which each component is uniformly mixed, and then subjected to melt mixing at a temperature of 100°C to 130°C using a heat kneader, cooled to room temperature, pulverized to a powder state, and then blended.

### 2. Semiconductor device

Another aspect of the present invention provides a semiconductor device comprising the epoxy resin composition.

The semiconductor device to which the composition of the present invention may be applied means an electronic circuit (an integrated circuit) made by integrating and wiring a transistor, a diode, a resistor, a capacitor, and the like on a semiconductor chip or on a substrate. A method for encapsulating and manufacturing a semiconductor device using the epoxy resin composition is not particularly limited. The semiconductor device may be manufactured by encapsulation using a molding method such as transfer molding, compression molding, or injection molding.

### MODE FOR CARRYING OUT THE INVENTION

Hereinafter, the present invention will be described in detail with reference to Examples.

However, the following Examples are merely illustrative of the present invention, and the present invention is not limited by the following Examples.

### [Examples and Comparative Examples]

The components of Table 1 below (Examples) and Table 2 below (Comparative Examples) were finely pulverized to obtain a powder, and then were uniformly mixed in predetermined blending amounts below, kneaded using a heated extruder, cooled, and then re-pulverized to prepare compositions.

**[Table 1]**

| Components | | Example | | | | | | |
|---|---|---|---|---|---|---|---|---|
| | | 1 | 2 | 3 | 4 | 5 | 6 | 7 |
| (A) | Biphenyl-type epoxy | 3.170 | 3.075 | 3.070 | 3.075 | 3.075 | 3.075 | 3.075 |
| | Dicyclopentadiene-type epoxy | 3.077 | 3.100 | 3.070 | 3.100 | 3.100 | 3.100 | 3.100 |
| (B) | Phenol aralkyl resin | 2.900 | 2.900 | 2.860 | 2.900 | 2.900 | 2.900 | 2.900 |
| | Phenol novolac resin | 1.000 | 1.000 | 1.000 | 1.000 | 1.000 | 1.000 | 1.000 |
| (C) | Silica (amorphous) | 87.000 | 87.000 | 87.000 | 87.000 | 87.000 | 87.000 | 87.000 |
| (D) | Methyltrimethoxy silane | 0.200 | 0.200 | 0.200 | 0.200 | 0.200 | 0.200 | 0.200 |
| | 3-(2-Aminoethyl)-3-Aminopropyl-Dimethoxylsilane | 0.100 | 0.100 | 0.100 | 0.100 | 0.100 | 0.100 | 0.100 |
| | 3-Mercaptopropyl-trimethoxvsilane | 0.100 | 0.100 | 0.100 | 0.100 | 0.100 | 0.100 | 0.100 |
| (E) | Imidazole-based compound (Average size 0.1 µm) | | | | 0.250 | | | |
| | Imidazole-based compound (Average size 0.5 µm) | | | | | 0.250 | | |
| | Imidazole-based compound (Average size 1.0 µm) | 0.010 | 0.250 | 0.500 | | | | |
| | Imidazole-based compound (Average size 2.5 µm) | | | | | | 0.250 | |
| | Imidazole-based compound (Average size 5.0 µm) | | | | | | | 0.250 |
| (F) | Metal hydroxide | 1.000 | 1.000 | 1.000 | 1.000 | 1.000 | 1.000 | 1.000 |
| (G) | Carnauba wax (natural) | 0.600 | 0.600 | 0.600 | 0.600 | 0.600 | 0.600 | 0.600 |
| (H) | Carbon black | 0.300 | 0.300 | 0.300 | 0.300 | 0.300 | 0.300 | 0.300 |
| (I) | Triphenyl phosphine | 0.543 | 0.375 | 0.200 | 0.375 | 0.375 | 0.375 | 0.375 |
| Total | | 100 | 100 | 100 | 100 | 100 | 100 | 100 |

**[Table 2]**

| Components | | Comparative Example | | | | | | |
|---|---|---|---|---|---|---|---|---|
| | | 1 | 2 | 3 | 4 | 5 | 6 | 7 |
| (A) | Biphenyl-type epoxy | 3.130 | 3.075 | 3.170 | 3.075 | 3.070 | 3.050 | 3.075 |
| | Dicyclopentadiene-type epoxy | 3.120 | 3.100 | 3.077 | 3.100 | 3.070 | 3.050 | 3.100 |
| (B) | Phenol aralkyl resin | 2.900 | 2.900 | 2.900 | 2.900 | 2.860 | 2.825 | 2.900 |
| | Phenol novolac resin | 1.000 | 1.000 | 1.000 | 1.000 | 1.000 | 1.000 | 1.000 |
| (C) | Silica (amorphous) | 87.000 | 87.000 | 87.000 | 87.000 | 87.000 | 87.000 | 87.000 |
| (D) | Methyltrimethoxy silane | 0.200 | 0.200 | 0.200 | 0.200 | 0.200 | 0.200 | 0.200 |
| | 3-(2-Aminoethyl) -3-Aminopropyl-Dimethoxylsilane | 0.100 | 0.100 | 0.100 | 0.100 | 0.100 | 0.100 | 0.100 |
| | 3-Mercaptopropyltrimethoxysilane | 0.100 | 0.100 | 0.100 | 0.100 | 0.100 | 0.100 | 0.100 |
| (E) | Imidazole-based compound (Average size 0.05 µm) | | 0.250 | | | | | |
| | Imidazole-based compound (Average size 10 µm) | | | 0.010 | 0.250 | 0.500 | 0.750 | |
| | Imidazole-based compound (Average size 20 µm) | | | | | | | 0.250 |
| (F) | Metal hydroxide | 1.000 | 1.000 | 1.000 | 1.000 | 1.000 | 1.000 | 1.000 |
| (G) | Carnauba wax (natural) | 0.600 | 0.600 | 0.600 | 0.600 | 0.600 | 0.600 | 0.600 |
| (H) | Carbon black | 0.300 | 0.300 | 0.300 | 0.300 | 0.300 | 0.300 | 0.300 |
| (I) | Triphenyl phosphine | 0.550 | 0.375 | 0.543 | 0.375 | 0.200 | 0.025 | 0.375 |
| Total | | 100 | 100 | 100 | 100 | 100 | 100 | 100 |

| | | | | | | | | |
|---|---|---|---|---|---|---|---|---|
| (A) Epoxy resin: Biphenyl-type epoxy (YX-4000K, produced by Japan Epoxy Co., Ltd), dicyclo pentadien-type epoxy (HP-7200, produced by DIC Co., Ltd) (B) Curing agent: Phenol aralkyl resin (MEH -7800SS, produced by Meihwa Co., Ltd), phenol novolac resin (KPH-F2001, produced by Kolon Co., Ltd) (C) Filler: Amorphous silica (FB-770, produced by Denka Co., Ltd) (D) Coupling agent: Methyltrimethoxy silane (TSL-8113, produced by Momentive Co., Ltd), 3-(2-Aminoethyl)-3-Aminopropyl-Dimethoxylsilane (KBM-602, produced by ShinEtsu Co., Ltd), 3-Mercapto propyl trimethoxysilane (KBM-803, produced by ShinEtsu Co., Ltd) (E) Adhesion promotor: Imidazole-based compound (Compound having the structure of Formula 1, and R₁ and R₂ are respectively a methylene group and a methyl group, produced by Shikoku Co., Ltd.) (F) Flame retardant: Metal Hydroxide (AOH, produced by Navaltech Co., Ltd.) (G) Release agent: Canava wax (C-Wax, produced by KAHL) (H) Coloring agent: Carbon Black (MA-600, produced by Mitsubishi Chemical Co., Ltd.) (I) Curing accelerator: Triphenyl phosphine (TPP, produced by HOKKO Chemical Co., Ltd.) | | | | | | | | |

### [Experimental Example]

The epoxy resin composition according to each of Examples and Comparative Examples was evaluated by the following method, and the evaluation results are shown in Table 3 and Table 4 below.

### Spiral flow

Using a spiral flow mold, molding was performed in a heat transfer molding device (pressure=70 kg/cm², temperature=175°C, curing time=120 seconds), and then the flowability of the epoxy resin composition was measured.

### Gelation time

A small amount of the epoxy resin composition produced according to each of Examples and Comparative Examples was spread widely and evenly over a gel timer to measure the gelation time of a product.

### Moisture absorption rate

A specimen having a thickness of 2 mm was molded, and then subjected to PMC (175°C, 4 hours). Thereafter, a forced absorption was performed for 24 hours in a PCT chamber (121°C, 2 atm, RH 100%) to measure the moisture absorption of the specimen.

### Adhesion (copper, nickel, silver)

The epoxy resin composition produced according to each of Examples and Comparative Examples was molded into a lead frame plated with copper, nickel, or silver and then subjected to PMC for 4 hours. Through a corresponding die shear measuring device, the adhesion between the epoxy resin composition and the boundary of the lead frame plated with copper, nickel, or silver was measured.

### Peeling

The epoxy resin composition produced according to each of Examples and Comparative Examples was molded directly into a corresponding power module package, and then subjected to PMC (175°C, 4 hours). Through a thermo-hygrostat, moisture absorption was performed for 192 hours at 30°C/60% RH, and a reflow process was performed at 260°C for three times to count the occurrence of peeling at the boundary between a Cu, Ni, or Ag plating surface inside the package and the epoxy resin composition, respectively. Analysis of the boundary peeling was performed using an ultrasonic microscope.

**[Table 3]**

| Classification | | | Example | | | | | | |
|---|---|---|---|---|---|---|---|---|---|
| | | | 1 | 2 | 3 | 4 | 5 | 6 | 7 |
| Spiral flow | | inch | 34 | 35 | 36 | 35 | 35 | 35 | 35 |
| Gelation time | | sec | 22 | 22 | 24 | 22 | 22 | 22 | 22 |
| Moisture absorption rate | | % | 0.28 | 0.28 | 0.28 | 0.28 | 0.28 | 0.28 | 0.28 |
| Adhesion | Cu | MPa | 13 | 13 | 12 | 12 | 12 | 12 | 12 |
| | Ni | MPa | 5 | 5 | 5 | 5 | 5 | 5 | 5 |
| | Ag | MPa | 6 | 6 | 6 | 6 | 6 | 6 | 6 |
| Peeling | Cu | Unit | 0/24 | 0/24 | 0/24 | 0/24 | 0/24 | 0/24 | 0/24 |
| | Ni | Unit | 0/24 | 0/24 | 1/24 | 1/24 | 0/24 | 0/24 | 1/24 |
| | Ag | Unit | 0/24 | 0/24 | 0/24 | 0/24 | 0/24 | 0/24 | 0/24 |

**[Table 4]**

| Classification | | | Comparative Example | | | | | | |
|---|---|---|---|---|---|---|---|---|---|
| | | | 1 | 2 | 3 | 4 | 5 | 6 | 7 |
| Spiral flow | | inch | 34 | 35 | 35 | 35 | 35 | 35 | 35 |
| Gelation time | | sec | 23 | 23 | 22 | 23 | 22 | 22 | 22 |
| Moisture absorption rate | | % | 0.28 | 0.28 | 0.28 | 0.28 | 0.28 | 0.28 | 0.28 |
| Adhesion | Cu | MPa | 6 | 12 | 12 | 12 | 12 | 12 | 12 |
| | Ni | MPa | 1 | 3 | 4 | 3 | 3 | 2 | 3 |
| | Ag | MPa | 2 | 4 | 5 | 4 | 4 | 3 | 4 |
| Peeling | Cu | Unit | 7/24 | 0/24 | 0/24 | 0/24 | 0/24 | 0/24 | 0/24 |
| | Ni | Unit | 20/24 | 5/24 | 5/24 | 7/24 | 8/24 | 10/24 | 9/24 |
| | Ag | Unit | 16/24 | 3/24 | 3/24 | 5/24 | 6/24 | 7/24 | 7/24 |

From the above results, it was confirmed that the epoxy resin composition of the present invention has excellent adhesion with a lead frame plated with copper, nickel and silver, and that a semiconductor device having high reliability when sealing a semiconductor element may be produced.

### INDUSTRIAL APPLICABILITY

The present invention provides an epoxy resin composition and a semiconductor device including the same, the composition having excellent adhesion to copper, nickel, and silver materials, and satisfying the reliability specification of a surface mount-type semiconductor for a car.

## Claims

1. An epoxy resin composition comprising:
an epoxy resin, a curing agent, a coupling agent, a curing accelerator, and an adhesion promotor, wherein the adhesion promotor comprises an imidazole-based compound having an average particle size of 0.1-5 µm.

2. The epoxy resin composition of claim 1, wherein the imidazole-based compound has an average particle size of 0.5-2.5 µm.

3. The epoxy resin composition of claim 1, wherein the imidazole-based compound has a chemical structure of Formula 1 below: 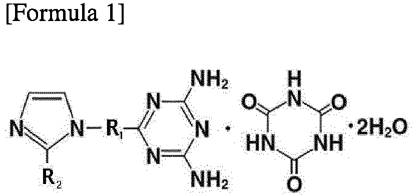 in Formula 1 above, R₁ is an alkylene group having 1 to 6 carbon atoms, and R₂ is an alkyl group having 1 to 6 carbon atoms.

4. The epoxy resin composition of claim 3, wherein R₁ is any one of a methylene group and an ethylene group, and R₂ is any one of a methyl group and an ethyl group.

5. The epoxy resin composition of claim 1, wherein the adhesion promotor is included in an amount of 0.01-0.5 parts by weight based on 100 parts by weight of the epoxy resin composition.

6. The epoxy resin composition of claim 1, wherein the epoxy resin is at least one selected from the group consisting of a bisphenol A-type epoxy resin, an alicyclic-type epoxy resin, a cresol novolac-type epoxy resin, a dicyclo pentadiene-type epoxy, and a biphenyl epoxy resin, and the epoxy resin contains two or more epoxy groups in one molecule.

7. The epoxy resin composition of claim 1, wherein the curing agent is at least one selected from the group consisting of a phenol novolac resin, a cresol novolac resin, a phenol aralkyl resin, and a polyfunctional phenol compound, and the curing agent contains two or more phenolic hydroxyl groups in one molecule.

8. The epoxy resin composition of claim 1, wherein the epoxy resin and the curing agent are mixed in an equivalent ratio of 1:0.6 to 1:1.3.

9. The epoxy resin composition of claim 1, wherein the coupling agent comprises at least one selected from the group consisting of epoxy silane, mercapto silane, and amino silane.

10. The epoxy resin composition of claim 1, wherein the curing accelerator comprises at least one selected from the group consisting of an amine-based compound and an organic phosphine compound.

11. The epoxy resin composition of claim 1, further comprising at least one selected from a filler group consisting of silica, silica nitride, alumina, aluminum nitride and boron nitride.

12. A semiconductor device comprising the epoxy resin composition as claimed in any one of claims 1 to 11.
